# EUROPÄISCHE PATENTSCHRIFT

(11) **EP 1 984 950 B1**
(45) Veröffentlichungstag und Bekanntmachung des Hinweises auf die Patenterteilung: **29.06.2011**
(21) Anmeldenummer: 07703311.6
(22) Anmeldetag: 06.02.2007
(51) Int. Cl.: H01L 23/34

(54) **BAUELEMENT MIT INTEGRIERTEM HEIZELEMENT UND VERFAHREN ZUM BEHEIZEN EINES HALBLEITERKÖRPERS**
COMPONENT WITH INTEGRATED HEATING ELEMENT AND METHOD FOR HEATING A SEMICONDUCTOR BODY
COMPOSANT AVEC ÉLÉMENT DE CHAUFFAGE INTÉGRÉ ET PROCÉDÉ DE CHAUFFAGE D'UN CORPS SEMI-CONDUCTEUR

(30) Priorität: 15.02.2006 DE 102006007040
(43) Veröffentlichungstag der Anmeldung: 29.10.2008
(73) Patentinhaber: Austriamicrosystems AG, 8141 Unterpremstätten (AT)
(72) Erfinder: ENICHLMAIR, Hubert, 8042 Graz (AT); KNAIPP, Martin, 8141 Unterpremstätten (AT)
(74) Vertreter: Epping - Hermann - Fischer
(86) Internationale Anmeldenummer: PCT/EP2007/001008
(87) Internationale Veröffentlichungsnummer: WO 2007/093304

(56) Entgegenhaltungen:
- EP-A1- 0 822 578
- EP-A1- 1 161 985
- EP-A2- 1 279 966
- DE-A1- 4 135 853
- US-A- 4 356 379
- MUTSCHALL D ET AL: "Basic Micro Module For Chemical Sensors With On Chip Heater And Buried Sensor Structure" 8TH INTERNATIONAL CONFERENCE ON SOLID-STATE SENSORS AND ACTUATORS AND EUROSENSORS IX. DIGEST OF TECHNICAL PAPERS, Bd. 1, 25. Juni 1995 (1995-06-25), Seiten 256-259, XP010304798
- APPELS J A ET AL: "THIN LAYER HIGH-VOLTAGE DEVICES (RESURF DIVICES)" PHILIPS JOURNAL OF RESEARCH, ELSEVIER, AMSTERDAM, NL, Bd. 35, Nr. 1, 1980, Seiten 1-13, XP000973657 ISSN: 0165-5817

## Beschreibung

Während und nach der Produktion von Halbleiterbauelementen werden üblicherweise diverse Testverfahren durchgeführt, um die Qualität der hergestellten Bauelemente zu testen. Um diese bereits auf Waferlevel durchzuführen, können die Bauelemente über die Waferauflage auf eine gewünschte Temperatur gebracht werden, bei der die entsprechenden Zuverlässigkeitstests dann durchgeführt werden. Nachteil dieser Methode ist jedoch, dass der Test mit einer solchen Aufheizung nur aufwendig durchzuführen ist und dass die Bauelemente dabei nur langsam aufgeheizt und auch langsam wieder abgekühlt werden können. Damit wird dieser Test zeitaufwendig.

Um solche Tests schneller und einfacher durchzuführen, wird in einem Artikel von Titel W. Muth, "Bias temperature instability assessment of n-and p-channel MOS transistors in polysilicon resistive heated scribe lane test structure", Microelectronics Reliability vol. 44, pp. 1251-1262, 2004 eine Teststruktur vorgeschlagen, die ein direktes Beheizen einer Halbleiterstruktur durch eine direkt auf dem Wafer aufgebrachte Widerstandsheizung umfasst. Dazu werden benachbart zu einer CMOS-Struktur zwei in Siliziumoxid eingebettete Polysilizium-Streifen vorgesehen, die als Widerstandsheizer fungieren. Eine Kontrolle der mit der Widerstandsheizung erzielten Aufheizung gelingt über die Bestimmung des Temperaturkoeffizienten einer Widerstandsleitung sowie über den temperaturabhängigen Vorwärtsstrom der CMOS Anordnung. Mit dieser Heizstruktur kann beispielsweise ein NBTI-Test (negative bias temperature instability) durchgeführt werden, wobei eine gewünschte Temperatur von beispielsweise 250° Celsius innerhalb von ca. 5 Sekunden erreicht werden kann.

US 4,356,379 beschreibt ein in eine integrierte Schaltung integriertes Heizelement. Eine temperatursensitive Schaltung ist beispielsweise in einem n-dotierten Bereich angeordnet. Das p-dotierte Heizelement befindet sich in einem weiteren n-dotierten Bereich, der die temperatursensitive Schaltung ringförmig umschließt und durch zwei konzentrische P+-Bereiche isoliert ist. Die Heizleistung wird über gegenüberliegende Kontakte in das Heizelement eingebracht.

EP 0 822 578 A1 beschreibt ein Verfahren zur Herstellung integrierter Halbleiterbauelemente mit chemoresistivem Gassensor.

DE 41 35 853 A1 beschreibt ein aktives Halbleiterbauelement mit regelbarer Wärmequelle.

EP 1 279 966 A2 beschreibt eine Vorrichtung und ein Verfahren für integrierte Halbleiterbauelemente, wobei ein Heizelement und ein Temperatursensor zum Einsatz gelangen.

EP 1 161 985 A1 beschreibt ein Verfahren zur Herstellung integrierter chemischer Mikroreaktoren und einen integrierten Mikroreaktor.

Aufgabe der vorliegenden Erfindung ist es, anzugeben, wie ein schnelleres Aufheizen eines Bauelementbereiches möglich ist und wie im genannten Messbereich eine hohe Temperaturgleichförmigkeit erzielt werden kann.

Diese Aufgabe wird erfindungsgemäß durch einen Halbleiterkörper mit den Merkmalen von Anspruch 1 beziehungsweise durch das Verfahren mit den Merkmalen von Anspruch 5 gelöst. Vorteilhafte Ausgestaltungen der Erfindung sind weiteren Ansprüchen zu entnehmen.

Der erfindungsgemäße Halbleiterkörper weist eine integrierte Heizstruktur auf, die eine diffundierte Zone in der Oberfläche des Halbleiterkörpers umfasst, die ein aufzuheizendes Gebiet im Abstand ringförmig umschließt. An zwei einander diametral gegenüberliegenden Stellen des diffundierten Gebietes sind elektrische Kontakte vorgesehen, die zum Verbinden der diffundierten Zone mit einer Stromquelle vorgesehen sind.

Durch Durchleiten eines Stromes durch die beiden Zweige der ringförmigen diffundierten Zone fungieren diese als Widerstandsheizelement, welches ein schnelles Aufheizen im Bereich der Heizstruktur ermöglicht. Im aufzuheizenden Gebiet kann dabei eine hohe Temperaturgleichmäßigkeit erzielt werden. Bei einem gegebenen Durchmesser des aufzuheizenden Gebiets von ca. 20 µm kann so eine Temperaturgleichmäßigkeit mit maximalen Temperaturunterschieden im aufzuheizenden Gebiet von typischerweise 4° Celsius erzielt werden.

Der Halbleiterkörper weist funktionelle Bauelementstrukturen auf, die im oder auf dem aufzuheizenden Gebiet angeordnet sind, und die beim oder zum bestimmungsgemäßen Betrieb eine über der Raumtemperatur liegende Betriebstemperatur erfordern. Das genaue Erreichen einer gewünschten Betriebstemperatur im Bereich der funktionellen Bauelementstrukturen wird mit einer Regelschleife und einen Temperatursensor gewährleistet.

Der Halbleiterkörper weist eine Grunddotierung von einem ersten Leitfähigkeitstyp auf, und die diffundierte zone ist mit einem Dotierstoff vom zweiten Leitfähigkeitstyp hochdotiert, sodass sich ein Halbleiterübergang zum Halbleiterkörper ausbilden kann. Auf diese Weise ist eine elektrische Isolation der als Widerstandsheizelement genutzten diffundierten Zone zum Halbleiterkörper hin gegeben. Dies hat den Vorteil, dass der Halbleiterkörper selbst auf ein nahezu beliebiges gegen die die diffundierte Zone negatives, von der integrierten Heizstruktur unabhängiges elektrisches Potential unterhalb der Durchbruchspannung gebracht werden kann, ohne dass sich dabei die unterschiedlichen Potentiale gegenseitig stören oder ein zu hoher Leckstrom zu beobachten ist.

Mit der vorgeschlagenen Heizstruktur ist es möglich, das aufzuheizende Gebiet im Rahmen der Spannungsfestigkeit auf mehr als 200° Celsius aufzuheizen. Dazu können in dem Ausführungsbeispiel Spannungen bis ca. 90 Volt an die beiden elektrischen Kontakte angelegt werden, ohne dass ein Durchbruch (break through) zum Substrat erfolgt.

Durch den Halbleiterübergang, mit dem die diffundierte Zone gegen den Halbleiterkörper isoliert ist, gelingt auch die elektrische Isolation des aufzuheizenden Gebiets gegen die diffundierte Zone. Daher ist es möglich, im aufzuheizenden Gebiet auch elektrische Bauelementstrukturen vorzusehen, die unabhängig von der Heizstruktur betrieben werden können. Als Bauelementstrukturen können z.B. Teststrukturen vorgesehen sein, anhand derer bei einer gewünschten Aufheiztemperatur bestimmte Parameter getestet werden. Möglich ist es jedoch auch, im aufzuheizenden Gebiet eine Sensoranordnung vorzusehen, mit der ein bestimmter äußerer oder innerer, bauelementeigener, physikalischer Parameter bei einer gewünschten Temperatur bestimmt wird, wobei die Sensoranordnung mit Hilfe der Heizstruktur auf die gewünschte Temperatur gebracht wird. Die Sensoranordnung kann einen biologischen, chemischen oder physikalischen Sensor umfassen.

Möglich ist es auch, den gewünschten Parameter innerhalb des aufzuheizenden Gebiets bei unterschiedlichen Temperaturen zu bestimmen, wobei die unterschiedlichen Temperaturen durch die genannten Mittel zum Regeln eingestellt werden, mit deren Hilfe der durch die diffundierte Zone fließende Strom gesteuert oder geregelt wird.

Im aufzuheizenden Gebiet kann außerdem ein Mikroreaktor vorgesehen sein, in dem bei einer gewünschten Aufheiztemperatur eine chemische oder mikrobiologische Reaktion durchgeführt wird. Dabei kann die Temperaturregelung so ausgebildet sein, dass ein Temperaturprogramm eingestellt wird, welches bestimmte Aufheizgeschwindigkeiten, Haltephasen und beliebige Endtemperaturen umfassen kann.

Zur Aufnahme von elektrischen Bauelementstrukturen ist im Halbleiterkörper im Bereich des aufzuheizenden Gebiets eine mit einem Dotierstoff vom zweiten Leitfähigkeitstyp dotierte zentrale Wanne ausgebildet, die von der diffundierten Zone beabstandet ist. Eine solche Wanne ist durch den Halbleiterübergang, der sich an ihrem Rand relativ zum Halbleiterkörper ausbildet, gegenüber letzterem elektrisch isoliert. Dementsprechend sind auch darin angeordnete Bauelementstrukturen elektrisch gegen den Halbleiterkörper isoliert. Die zentrale Wanne kann mit einem eigenem elektrischen Potential beaufschlagt werden. Dazu ist in deren Randbereich ein vorzugsweise konzentrisch zur diffundierten Zone angeordneter Wannenring vorgesehen, der eine gegenüber der zentralen Wanne erhöhte Dotierung vom zweiten Leitfähigkeitstyp aufweist und der mit einem Wannenkontakt verbunden ist. Über den Wannenkontakt kann ein gewünschtes elektrisches Potential an die Wanne angelegt werden.

Eine weiter verbesserte elektrische Isolation von innerhalb der zentralen Wanne angeordneten Bauelementstrukturen wird erreicht, indem zwischen diffundierter Zone und zentraler Wanne und vorzugsweise konzentrisch zur diffundierten Zone ein ringförmig geschlossener innerer Substratring vorgesehen wird, welcher eine gegenüber der Grunddotierung des Halbleiterkörpers erhöhte Dotierung vom ersten Leitfähigkeitstyp aufweist und mit einem Substratkontakt verbunden ist. Über den Substratkontakt kann ein gewünschtes elektrisches Potential an den Halbleiterkörper angelegt werden.

Zudem ist außerhalb der diffundierten Zone und ebenfalls vorzugsweise konzentrisch dazu ein ringförmig geschlossener äußerer Substratring mit einer gegenüber der Grunddotierung erhöhten Dotierung vom ersten Leitfähigkeitstyp angeordnet und mit einem weiteren Substratkontakt verbunden. Damit gelingt eine verbesserte Isolation der diffundierten Zone gegenüber außerhalb des äußeren Substratrings in dem Halbleiterkörper angeordneten weiteren Bauelementstrukturen.

Eine hohe Durchschlagsfestigkeit wird erreicht, wenn sich unterhalb der diffundierten Zone eine ausreichend große Raumladungszone ausbildet, die von freien Ladungsträgern entleert ist. Dies kann erreicht werden, indem der Halbleiterkörper eine nur schwache Grunddotierung aufweist. Vorteilhaft weist der Halbleiterkörper einen spezifischen Widerstand von typischerweise 20 Ohm cm auf.

Eine weiter verbesserte Durchbruchsfestigkeit wird mit einem speziell gestalteten Dotierprofil innerhalb der diffundierten Zone erreicht, das den RESURF-Effekt nutzt.

Dazu umfasst eine in der Oberfläche des Halbleiterkörpers ausgebildete im Querschnitt flache Wanne vom zweiten Leitfähigkeitstyp die hochdotierte oberflächennahe Zone vom gleichen Leitfähigkeitstyp, die als Heizquelle fungiert. In diese schwach dotierte Wanne ist zentral ein relativ hoch dotiertes Gebiet vom zweiten Leitfähigkeitstyp angeordnet. Auf diese Weise wird erreicht, dass das durch die Dotierung erzeugte elektrische Feld sowohl vertikal als auch horizontal verringert wird. Dadurch wird die Grenzspannung, bei der ein elektrischer Durchbruch vertikal oder horizontal einsetzt, erhöht.

Die räumliche Ausdehnung der diffundierten Zone ist sowohl von der gewünschten elektrischen Leistung als auch von der gewünschten Spannungsfestigkeit abhängig. Die Feldverteilung wiederum bestimmt zum Teil die Durchbruchsspannung und damit ebenfalls die an die Heizstruktur anlegbare maximale elektrische Spannung. Die geometrischen Abmessungen der Heizstruktur sowie deren Dotierstoffkonzentration bestimmen den bei der maximal möglichen elektrischen Spannung fließenden Strom. Daraus ergibt sich die maximal einprägbare Verlustleistung.

In einem Beispiel kann die diffundierte Zone beispielsweise mit einem Heizstrom einer Leistung von 3,5 Watt, die bei 90 Volt erreicht werden, betrieben werden. Damit ist es möglich, im aufzuheizenden Gebiet eine Spitzentemperatur von mehr als 200° Celsius zu erzielen, die auf einem Temperaturplateau mit einem Durchmesser von ca. 20 µm um maximal 4° Celsius schwankt. Dies wird mit einer ringförmig geschlossenen diffundierten Zone erreicht, die einen Durchmesser (Abstand der beiden Zweige) von ca. 60 µm aufweist.

Bei Erhöhung der Stromtragfähigkeit gelingt eine weitere Steigerung der maximalen Aufheiztemperatur im aufzuheizenden Gebiet und bei Erweiterung des Durchmessers der diffundierten Zone ist es auch möglich, den Durchmesser des temperaturstabilen aufzuheizenden Gebiets weiter zu erhöhen. In allen Fällen führt die ausgesprochen gute thermische Diffusivität von kristallinen Silizium mit D = 0,9 cm²/s zu einem schnellen Einstellen des Temperaturgleichgewichts und damit zu einem schnellen Erreichen der gewünschten Aufheiztemperatur innerhalb von weniger als ca. 1 ms. Da auch die Abkühlung in ähnlichen Zeitspannen erfolgt, können im erfindungsgemäßen Halbleiterkörper mit der Heizstruktur innerhalb kürzester Zeit zahlreiche Aufheiz- und Abkühlzyklen gefahren werden, die ein ausführliches und umfangreiches Testen bzw. Messen von Parametern innerhalb des aufzuheizenden Gebiets ermöglichen.

Die diffundierte Zone kann geometrisch den Kanten eines Rechtecks folgen, wobei dann die beiden elektrischen Kontakte an den Mitten zweier gegenüberliegender Rechtecksseiten angeordnet sind. Dies ermöglicht einen gleichmäßigen Wärmefluss in Richtung Zentrum des Rechtecks, in dem das aufzuheizende Gebiet angeordnet ist. Durch entsprechende Längenbemessung des Rechtecks kann das aufzuheizende Gebiet auf eine Länge von mehreren Hundert µm verlängert werden, ohne dass die Temperaturgleichmäßigkeit des aufzuheizenden Gebiets dadurch beeinträchtigt ist. Die Schmalseite des Rechtecks bzw. deren Abmessungen bestimmt die Breite des aufzuheizenden Gebiets, die jedoch zusätzlich noch von der gewünschten Temperaturgleichmäßigkeit abhängig ist. Begnügt man sich mit einer geringeren Temperaturgleichmäßigkeit, so erweitert sich das aufzuheizende Gebiet, das diese Temperaturgleichmäßigkeit aufweist, entsprechend.

Im Folgenden wird die Erfindung anhand von Beispielen und Ausführungsbeispielen und der dazugehörigen Figuren näher erläutert. Die Figuren sind rein schematisch und nicht maßstabsgetreu, sodass ihnen weder absolute noch relative Maßangaben zu entnehmen sind.
Figur 1 zeigt einen Halbleiterkörper mit Heizstruktur in der Draufsicht und im schematischen Querschnit. Figur 1 zeigt nicht alle Merkmale der beanspruchten Erfindung.
Figur 2 zeigt erreichbare Endtemperaturen in Abhängigkeit von der zugeführten Leistung und der angelegten Spannungspegel,
Figur 3 zeigt ein Ausführungsbeispiel eines erfindungsgemäßen Halbleiterkörpers mit Heizstruktur im schematischen Querschnitt,
Figur 4 zeigt die Feldverteilung im Bereich der diffundierten Zone anhand eines schematischen Querschnitts,
Figur 5 zeigt den Leckstrom zwischen diffundierter Zone und Substrat in Abhängigkeit von der angelegten Spannung,
Figur 6 zeigt eine zweidimensionale Temperaturverteilung anhand eines schematischen Querschnitts bzw. eine eindimensionale Temperaturverteilung entlang der Oberfläche des Halbleiterkörpers und
Figur 7 zeigt ein weiteres Ausführungsbeispiel eines Halbleiterkörpers mit Heizstruktur in der Draufsicht.

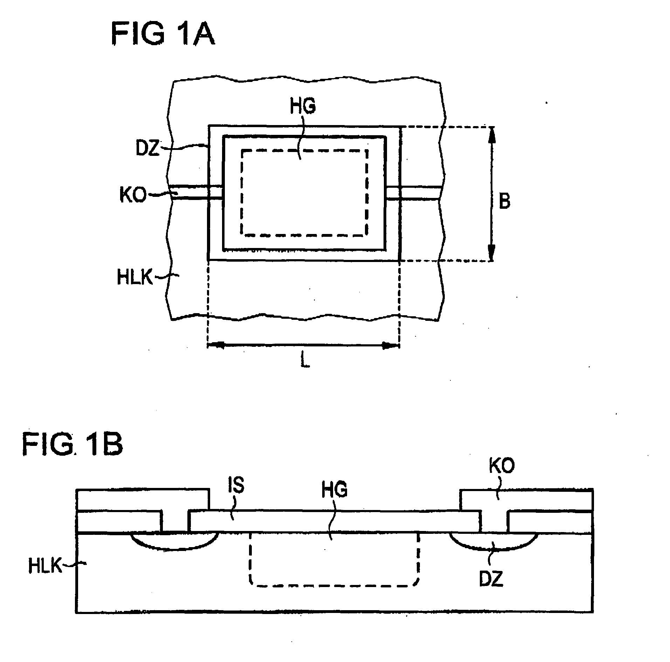

Figur 1a zeigt einen Halbleiterkörper mit Heizstruktur in der Draufsicht und im schematischen Querschnitt. Figur 1a zeigt nicht alle Merkmale der beanspruchten Erfindung. In einem Halbleiterkörper HLK ist eine einfache Heizstruktur in Form einer diffundierten Zone DZ in die Oberfläche des Halbleiterkörpers eingebracht. Die diffundierte Zone ist ringförmig geschlossen und weist beispielsweise eine Rechecksform auf. Die elektrischen Kontakte sind an zwei einander gegenüberliegenden Seitenkanten des Rechtecks angeordnet und dienen zur Stromzu- bzw. -abführung der als Widerstandheizelement fungierenden diffundierten Zone DZ. Von der diffundierten Zone DZ umschlossen ist das aufzuheizende Gebiet HG angeordnet. Die ringförmig diffundierte Zone DZ hat eine Länge L und eine Breite B.

Figur 1b zeigt den Halbleiterkörper mit Heizstruktur im schematischen Querschnitt. Figur 1b zeigt nicht alle Merkmale der beanspruchten Erfindung. Der Halbleiterkörper umfasst vorzugsweise kristallines und niedrig dotiertes Silizium.

In den diffundierten Zonen DZ wird eine hohe Dotierstoffkonzentration von beispielsweise 10²⁰ cm⁻³ eingebracht. Für eine günstige Feldverteilung wird diese hohe Dotierungsstärke relativ flach eingebracht, beispielsweise in einer Tiefe bis 200 nm bei einer Breite von ca. 2 µm. Für eine größere gewünschte Stromtragfähigkeit innerhalb der diffundierten Zone wird der dotierte Querschnitt erhöht, indem die diffundierte Zone verbreitert wird. Während der Halbleiterkörper HLK mit einem Dotierstoff vom ersten Leitfähigkeitstyp dotiert ist, wird die diffundierte Zone vorzugsweise mit einem Dotierstoff vom zweiten Leitfähigkeitstyp dotiert, sodass sich ein pn-Übergang zum Halbleiterkörper hin ausbildet. Die im Bereich des Halbleiterübergangs entstehende von freien Ladungsträgern entleerte Raumladungszone isoliert die diffundierte Zone gegen das Substrat bzw. den Halbleiterkörper.

An der Oberfläche kann der Halbleiterkörper mit einer isolierenden Schicht IS, beispielsweise einer Oxidschicht abgedeckt sein. Mittels zweier durch die isolierende Schicht IS reichender Öffnungen und darin eingebrachten elektrisch leitenden Materials werden Kontakte KO für die durch die diffundierte Zone gebildete Heizstruktur gebildet. Die Kontakte KO sind beispielsweise metallisch.

Im Bereich des aufzuheizenden Gebiets kann ein Temperatursensor vorgesehen sein (in der Figur nicht dargestellt). Ebenfalls nicht dargestellt sind die funktionellen Bauelementstrukturen, die im oder auf dem aufzuheizenden Gebiet angeordnet sind. Die weiteren Mittel und insbesondere eine die Regelschleife realisierende Schaltung können an anderer Stelle in dem Halbleiterkörper integriert ausgebildet sein oder in Form eines diskreten Bauelements auf dem Halbleiterkörper angeordnet oder extern angeordnet und mit dem Temperatursensor elektrisch verbunden sein.

Durch Beaufschlagung der Kontakte KO mit einem Strom fungiert die diffundierte Zone DZ als Widerstandsheizung, die in der Folge zu einer Aufheizung des im Inneren der ringförmigen diffundierten Zone angeordneten Gebiets führt. Dort ist das bezüglich seiner Grenzen virtuell angenommene aufzuheizende Gebiet HG vorgesehen, dessen Außengrenzen sich in einem bestimmten, von der gewünschten Temperaturgleichmäßigkeit abhängigen Abstand zur diffundierten Zone befinden. Die Temperaturverteilung weist dann im Bereich des aufzuheizenden Gebiets HG ein weitgehend ebenes Plateaus mit nur geringen relativen Temperaturunterschieden auf, während die Temperatur zur diffundierten Zone hin wieder steil ansteigt.

Der Vorteil dieses Aufbaus liegt darin, dass zwischen der Heizquelle, also zwischen der diffundierten Zone und dem aufzuheizenden Gebiet HG keine Phasengrenze verläuft, so dass eine weitgehend homogene bzw. ungehinderte Aufheizung möglich ist. Unterstützt wird die homogene Aufheizung durch die ausgezeichnete thermische Diffusivität von Silizium, die bei D = 0,9 cm²/Sekunde liegt (bei Raumtemperatur). Dies führt dazu, dass eine thermische Diffusionslänge von 100 µm innerhalb eines Zeitintervalls in der Größenordnung von ca. 10 ms erreicht wird. Dies führt dazu, dass im aufzuheizenden Gebiet (bei einer Breite B (= Innendurchmesser des Rings) der diffundierten Zone DZ von ca. 100 µm) die gewünschte Endtemperatur sehr schnell und im Ausführungsbeispiel innerhalb einer Zeitspanne von weniger als einer Millisekunde erreicht werden kann. Mit den genannten Bemessungen kann hier die Endtemperatur mehr als 200° Celsius betragen. Dabei wird eine maximale Leistung von 3,5 Watt in die diffundierte Zone eingespeist, die sich aus der maximalen Spannung und der maximalen Stromtragfähigkeit der Kontakte KO und der diffundierten Zone DZ ergibt. Die maximal anlegbare Spannung entspricht der Spannung, bei der ein elektrischer Durchbruch zum Substrat sicher verhindert wird.

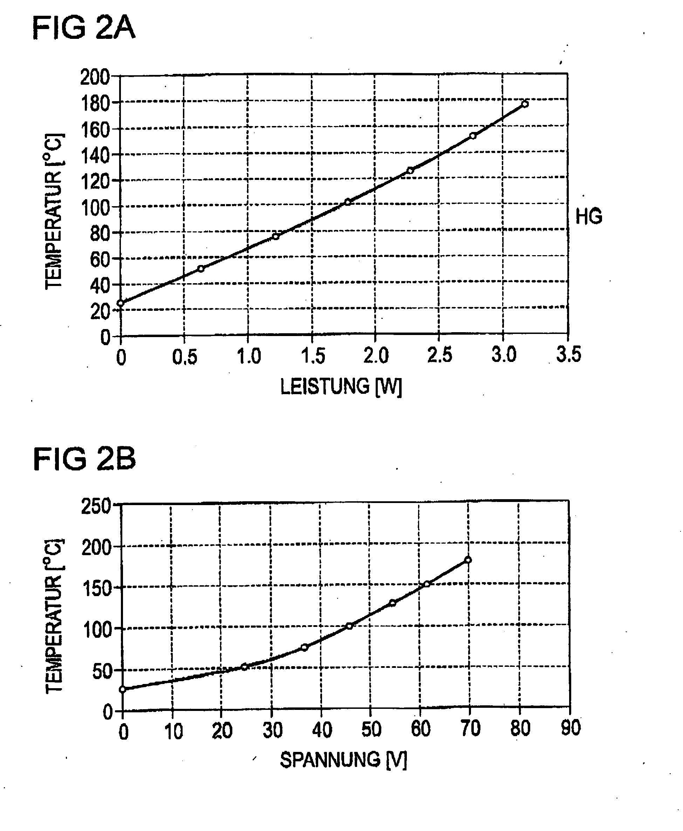

Figur 2a zeigt den Temperaturanstieg im Zentrum des aufzuheizenden Gebiets HG in Abhängigkeit von der zugeführten Leistung. Es zeigt sich, dass die erreichbare Endtemperatur nahezu linear mit der eingespeisten Leistung ansteigt. Die zugeführte Leistung kann über die anliegende Spannung geregelt werden. Figur 2b zeigt den Temperaturanstieg in Abhängigkeit von der anliegenden Spannung. Im vorliegenden Fall wird eine Durchbruchsspannung von ca. 90 Volt bestimmt, sodass das Bauelement bis ca. 70 Volt ohne Gefahr eines elektrischen Durchbruchs betreibbar ist.

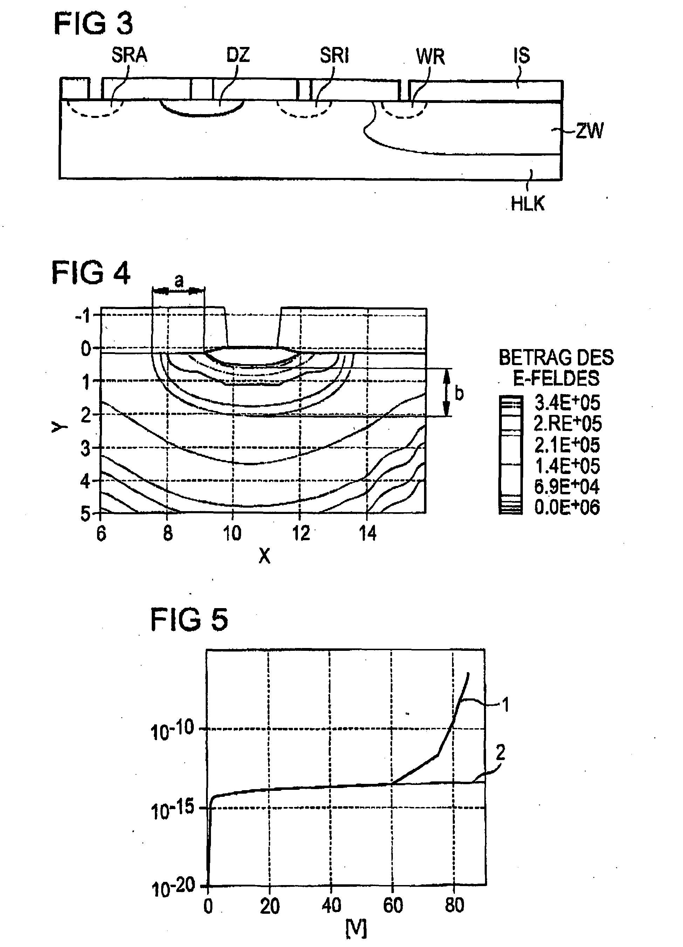

Figur 3 zeigt eine Ausführung der Erfindung, bei der zum einen die Spannungsfestigkeit der Anordnung weiter erhöht ist und bei der das aufzuheizende Gebiet elektrisch besser gegen die diffundierte Zone isoliert ist. Letzteres wird erreicht durch eine im Bereich des aufzuheizenden Gebiets HG angeordnete zentrale Wanne ZW, die mit einem Dotierstoff vom zweiten Leitfähigkeitstyp dotiert ist. Die Tiefe dieser zentralen Wanne wird in Abhängigkeit von dem im aufzuheizenden Gebiet anzuordnenden Bauelement bzw. den Bauelementstrukturen gewählt.

Die verbesserte elektrische Isolation ergibt sich durch den zusätzlichen pn-Übergang zwischen Halbleiterkörper und zentraler Wanne ZW. Zwischen diffundierter Zone DZ und zentraler Wanne wird ein mit einem Dotierstoff vom ersten Leitfähigkeitstyp höher dotierter innerer Substratring SRI vorgesehen, in den die Dotierstoffkonzentration in einem engen Bereich bis ca. 10²⁰ cm³ erhöht ist. Außerhalb des von der diffundierten Zone DZ umschlossenen Gebiets ist im Abstand zu dieser ein äußerer Substratring SRA angeordnet, der ähnlich wie der innere Substratring SRI aufgebaut ist und die diffundierte Zone ringförmig umschließt. Beide Substratringe SRI/SRA sind jeweils mit einem Substratkontakt verbunden, über den ein elektrisches Potential an das Substrat angelegt werden kann. Das elektrische Potential für die zentrale Wanne ZW wird über eine weitere ringförmig geschlossene höher dotierte Zone im Randbereich der zentralen Wanne vorgesehen. Dieser Wannenring WR ist mit einem Dotierstoff vom zweiten Leitfähigkeitstyp höher dotiert als die zentrale Wanne und über einen (in der Figur nicht dargestellten) Wannenkontakt mit einem Potential verbunden, welches an die zentrale Wanne ZW angelegt werden soll.

Figur 4 zeigt anhand eines schematischen Querschnitts durch den Halbleiterkörper im Bereich der diffundierten Zone den simulierten Verlauf des elektrischen Felds. Es zeigt sich, dass das Feld sowohl vertikal als auch lateral mit einem nur geringen Feldgradienten abfällt. Dies führt zu einer relativ hohen Durchbruchsspannung. Der günstige Feldverlauf wird durch das Dotierprofil im Bereich der diffundierten Zone DZ erreicht, die aus einem zentralen hoch dotierten Bereich besteht, welcher in einer etwas größeren schwächer dotierten und räumlich umfangreicheren Wanne angeordnet ist. Das gewünschte Dotierprofil kann durch geeignete Größenbemessung der schwächer dotierten Wanne und des hoch dotierten Zentrums darin bestimmt und durch geeignete Ionenimplantationsprozesse und ein geeignetes thermisches Budget für die flache Wanne erzeugt werden. Der gewünschte Feldlinienverlauf wird durch den RESURF-Effekt erreicht. In dem in Figur 4 dargestellten Ausführungsbeispiel erstreckt sich die Raumladungszone in lateraler Richtung (parallel zur Oberfläche des Halbleiterkörpers) innerhalb der schwächer dotierten Bereiche über einen größeren Bereich (a) als in vertikaler Richtung (b). Erst diese Ausführung hilft die Abbruchspannung des hoch diffundierten Bereichs deutlich anzuheben und somit die notwendige Leistung einzuprägen, da der laterale Oberflächenabbruch vermieden wird (RESURF).

Aufgrund der niedrigen Dotierstoffkonzentration des Halbleiterkörpers kann sich die Raumladungszone bis eine Tiefe von mehreren 10 µm erstrecken. Der innere Substratring SRI bewirkt eine hohe Punch-Through-Spannung zwischen der diffundierten Zone und der zentralen Wanne ZW. Durch die Anordnung des inneren Substratrings SRI kann der Abstand zwischen der diffundierten Zone und der zentralen Wanne reduziert werden, ohne dass die elektrische Isolation darunter leidet.

Die Zentrale Wanne ist nun elektrisch vollständig gegen die diffundierte Zone DZ isoliert. Darin angeordnete elektrische Bauelementstrukturen, welche beispielsweise als MOS-Transistoren, Bipolar-Transistoren, Kondensatoren, Widerstände oder Halbleiterschaltungen ausgebildet sind, können in gewohnter Weise und völlig ungestört betrieben werden, ohne dass eine Design- oder Layoutanpassung innerhalb der zentralen Wanne erforderlich ist.

Figur 5 zeigt das Leckstromverhalten, gemessen zwischen den an die diffundierte Zone DZ angelegten elektrischen Kontakten KO und der zentralen Wanne für eine Ausführung mit innerem Substratring SRI (Kurve 2) bzw. ohne inneren Substratring (Kurve 1). Es zeigt sich, dass ohne inneren Substratring SRI bereits oberhalb von 60 Volt ein starker Anstieg des Leckstroms auftritt, der mit Hilfe des inneren Substratrings bis ca. 90 Volt vollständig vermieden werden kann.

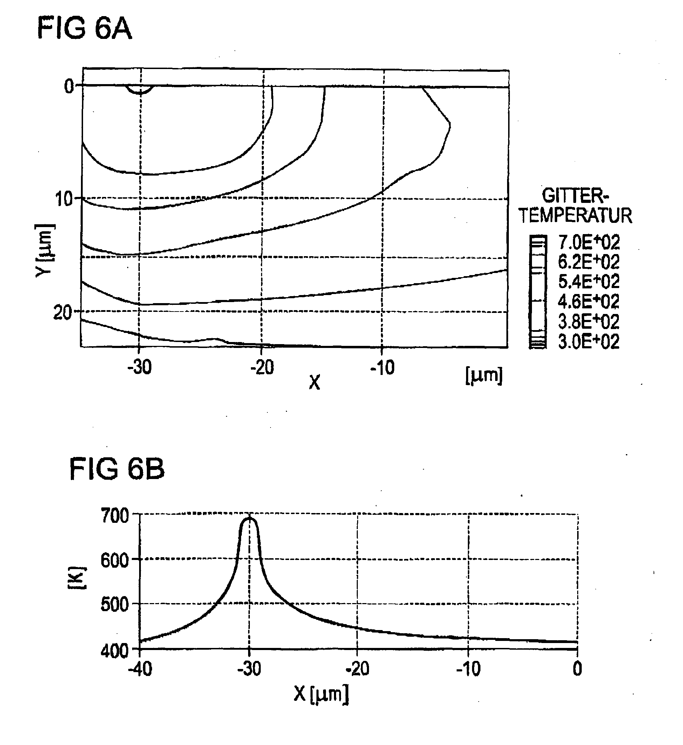

Figur 6 zeigt die mit der erfindungsgemäßen Anordnung erreichbare Temperaturverteilung anhand eines schematischen Querschnitts durch den Halbleiterkörper mit den eingezeichneten Isothermen (Figur 6a) bzw. in Fig. 6b eine eindimensionale Temperaturverteilung, die an der Oberfläche des Halbleiterkörpers bzw. an der Grenzfläche zwischen dem Silizium des Halbleiterkörpers und der isolierenden Schicht, bzw. dem dafür verwendeten Siliziumoxid gemessen ist. Dargestellt ist nur die Hälfte der Anordnung, zu der die nicht dargestellte zweite Hälfte spiegelsymmetrisch ist. Der Nullpunkt (rechte Kante in der Darstellung) entspricht der Mitte des aufzuheizenden Gebiets, während die diffundierte Zone auf der dargestellten Längenskala bei ca. 29 µm angeordnet ist. Dies bedeutet, dass der von der diffundierten Zone gebildete Ring einen Durchmesser von ca. 60 µm aufweist. Aus der Darstellung ergibt sich, dass die Temperaturverteilung gleichförmig ist und insbesondere in der Mitte äußerst homogen. Dieser Bereich ist daher gut geeignet zur Aufnahme einer Vielzahl unterschiedlichster funktioneller Bauelementstrukturen, die zur bestimmungsgemäßen Funktion eine bestimmte gut einstellbare bzw. über die Fläche gleichmäßige Temperatur erfordern. Auch die Größe der zur Verfügung stehenden Fläche mit gleichförmiger Temperaturverteilung ist zur Aufnahme unterschiedlichster funktioneller Bauelementstrukturen voll ausreichend.

Die Temperaturverteilung gemäß Figur 6b zeigt, dass die höchste Temperatur naturgemäß im Bereich der diffundierten Zone erreicht wird, die im Ausführungsbeispiel bei ca. 700° Kelvin liegt. Zur Mitte des Rings hin nimmt die Temperatur steil ab und läuft dann in einem flachen Plateau bei etwa 420° Kelvin aus, in dem beim Aufheizen eine hohe Temperaturgleichförmigkeit besteht. Es zeigt sich, dass im Bereich zwischen 0 und 10 µm auf der Skala, also bei der gesamten Anordnung in einem Bereich von ca. 20 µm Durchmesser, eine Temperaturgleichmäßigkeit erreicht wird, bei der die Temperatur maximal um 4° Kelvin schwankt. Dieser Wert ist ausreichend, innerhalb des aufzuheizenden Gebiets die bei bestimmten Temperaturen durchzuführenden Messungen oder Testverfahren mit ausreichender Genauigkeit durchzuführen. Figur 6a zeigt außerdem, dass sich die Temperaturgleichmäßigkeit im Zentrum des aufzuheizenden Gebiets HG auch bis in eine große Tiefe von bis ca. 10 µm erstreckt, sodass zu testende oder zu messende Bauelementstrukturen auch in größere Tiefen des Halbleiterkörpers eingebracht werden können, ohne dass die Temperaturgleichmäßigkeit dort abnimmt.

Aus der Temperaturverteilung gemäß Figur 6b ergibt sich außerdem, dass die Temperaturunterschiede zwischen der maximalen Temperatur im Bereich der diffundierten Zone und der minimalen Temperatur in der Mitte des aufzuheizenden Gebiets relativ gering sind und im Ausführungsbeispiel nur ca. 370° Kelvin betragen. Dies ist ein deutlich geringerer Wert, als es mit einer bekannten integrierten Heizanordnung mit Polysilizium-Heizstreifen zwischen zwei Isolationsschichten erzielt werden kann. Dies zeigt die Überlegenheit der vorgestellten neuen Lösung, bei der der Wärmefluss wieder durch thermisch schlecht leitendes Oxid noch durch irgendwelche Grenzflächen zwischen unterschiedlichen Phasen oder Materialien behindert wird. Die relativ geringe maximale Temperatur von ca. 700° Kelvin im Zentrum der diffundierten Zone ist außerdem ausreichend niedrig, dass keine gravierenden Veränderungen am Dotierprofil während des Aufheizprozesses zu befürchten sind. Die Anordnung bleibt daher auch über eine Vielzahl von Aufheizzyklen in ihrer Struktur insbesondere im Dotierprofil stabil und kann über eine Vielzahl von Aufheiz- und Abkühlzyklen zuverlässig betrieben werden.

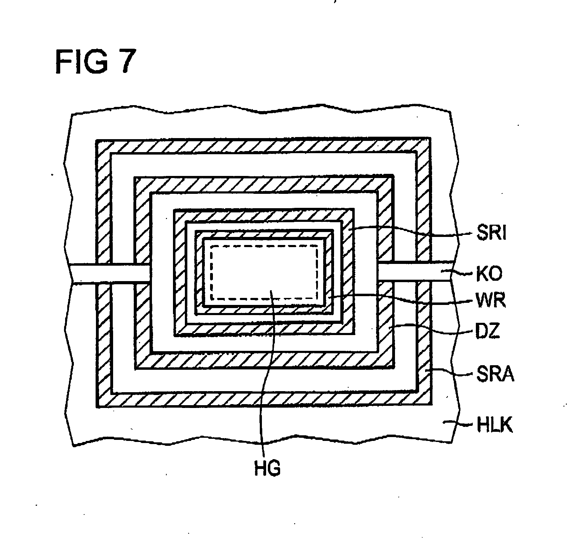

Figur 7 zeigt in einer schematischen Draufsicht eine mögliche zweidimensionale Anordnung des bereits in Figur 3 anhand eines schematischen Querschnitts dargestellten Ausführungsbeispiels. Sämtliche schraffiert dargestellten ringförmigen Zonen sind durch Implantation eines geeigneten Dotierstoffs hergestellt. Die Abstände an den Längsseiten sind entsprechend den Designregeln festgelegt. So ist beispielsweise die diffundierte Zone DZ von einem äußeren Substratring SRA umgeben und schließt einen inneren Substratring SRI ein. Innerhalb des inneren Substratrings ist die zentrale Wanne ZW angeordnet, in die durch den Wannenring WR, der ebenfalls eine höher dotierte ringförmig geschlossene Zone darstellt, elektrisch mit dem Wannenpotential kontaktiert.

Im Inneren des Wannenrings ist das aufzuheizende Gebiet HG vorgesehen, welches elektrisch vollständig gegenüber der diffundierten Zone DZ isoliert ist und welches beim Aufheizen die genannte hohe thermische Homogenität aufweist. Die beiden elektrischen Kontakte KO für die diffundierte Zone sind bis auf den direkten Kontakt mit der diffundierten Zone gegen den Halbleiterkörper isoliert, beispielsweise durch eine dazwischen liegende Isolierschicht und insbesondere eine dazwischen liegende Siliziumoxidschicht. Nicht dargestellt sind die entsprechenden Kontakte für inneren und äußeren Substratring sowie für den Wannenring. Auch die Bauelementstrukturen, die innerhalb des aufzuheizenden Gebiets HG angeordnet werden können, bedürfen üblicherweise mindestens elektrischer Anschlüsse, die ebenfalls in gewohnter Weise durch die Isolierschicht IS gegen den Halbleiterkörper HLK getrennt zugeführt werden können.

Die im Innern des aufzuheizenden Gebietes HG angeordneten funktionellen Bauelementstrukturen können reine Teststrukturen darstellen, die im Rahmen eines Halbleiterproduktionsprozesses zusammen mit anderen für das Bauelement funktionellen Bauelementstrukturen erzeugt werden und anhand derer die erfolgreiche Durchführung der Prozesse bzw. die Zuverlässigkeit der erzeugten Strukturen getestet werden kann. Dies kann auch bereits während des Herstellungsverfahrens erfolgen.

Die beispielsweise in Figur 7 dargestellte Anordnung kann daher auf einem beliebigen Bauelementwafer miterzeugt werden und gegebenenfalls sogar auf jedem einzelnen Bauelement selbst vorgesehen sein. Die Anzahl pro Wafer oder pro Bauelement vorzusehenden Teststrukturen kann in Abhängigkeit vom gewünschten Grad der Prozesskontrolle gewählt werden. Der Bereich des Halbleiterkörpers mit der Heizstruktur und den Teststrukturen im aufzuheizenden Gebiet kann auch als separates Bauteil miterzeugt werden oder kann als Strukturelement auf einem erzeugten Bauelement verbleiben, wo es den weiteren Betrieb des Bauelements nicht stört.

Gut geeignet sind Anwendungen des Halbleiterkörpers mit der integrierten Heizstruktur für alle Bauelemente oder Bauelementteile, die in bestimmungsgemäßen Betrieb auf eine bestimmte erhöhte Temperatur gebracht werden müssen. Beispiele solcher Anwendungen sind beispielsweise chemische oder physikalische Sensoren, die entweder bei erhöhten Temperaturen betrieben werden müssen, oder die Messungen bei unterschiedlichen Temperaturen erfordern, die mit Hilfe der erfindungsgemäßen Anordnung in sicherer und schneller Weise eingestellt werden können. Beispiele für solche Anwendungen sind Bandlückenspannungsreferenzen (band gap voltage reference), sowie Sensoren, insbesondere chemische Sensoren.

Die Heizstruktur kann auch dazu verwendet werden, bestimmte thermische Reaktionsbedingungen für biologische oder chemische Mikroreaktoren zu erzeugen. Solche Mikroreaktoren sind unter dem Begriff "Lab on Chip" bekannt und umfassen beispielsweise eine Mehrzahl von in die Oberfläche des Halbleiterkörpers geätzten Vertiefungen, die mit Zuführungskanälen und Verbindungskanälen versehen sind. In den Vertiefungen können einzelne Stoffe bevorratet werden und/oder unterschiedliche Stoffe miteinander umgesetzt werden. In den Mikroreaktor integriert können Bauelementstrukturen sein, mit deren Hilfe bestimmte Messungen während der Umsetzung oder zur Analyse des mit der Umsetzung erzielten Ergebnisses durchgeführt werden können.

Da der größte Vorteil der vorgeschlagenen Anordnung jedoch darin besteht, dass die Aufheiz- und Abkühlzyklen im Millisekundenbereich durchgeführt werden können, ist ein bevorzugter Einsatzbereich der erfindungsgemäßen Anordnung bei solchen Bauelementen und Teststrukturen gegeben, bei denen eine schnelle Durchführung der Messungen von Vorteil ist, oder bei denen eine Vielzahl von Messungen durchgeführt werden müssen.

Die Erfindung wurde zwar nur anhand weniger Ausführungsbeispiele dargestellt, ist aber nicht auf diese beschränkt. Der Schutzumfang ergibt sich aus den Ansprüchen. Die zweidimensionale Anordnung der Heizstruktur bzw. der diffundierten Zone DZ und aller konzentrisch dazu angeordneten weiteren implantierten Ringe ist nicht auf die als bevorzugtes Ausführungsbeispiel dargestellte Rechtecksform beschränkt. Möglich ist es auch, die diffundierte Zone an den Ecken abzurunden oder mit runder, elliptischer oder ovaler Ausformung zu realisieren.

Entscheidend für das Temperaturprofil einer Heizanordnung gemäß Figur 1a ist die Größe B, welche üblicherweise dem kleineren Durchmesser der diffundierten Zone entspricht. So ist das in Figur 6 dargestellte Temperaturprofil beispielsweise parallel zur Breite B gemessen. Aufgrund der geometrischen Regelmäßigkeit der Anordnung findet sich dieses Profil in nahezu unveränderter Form entlang eines jeden Querschnitts parallel zu B innerhalb des aufzuheizenden Gebiets HG.

Dementsprechend ist es auch möglich, die Länge L der Anordnung beliebig zu erhöhen, ohne dass sich dabei das Temperaturprofil quer dazu verändert. Diffundierte Zonen mit größerer Länge L weisen ein größeres aufzuheizendes Gebiet auf, in dem dann eine größere Anzahl von Bauelementen, oder Teststrukturen oder Mikroreaktoren angeordnet werden kann. Vorteilhaft liegen die Breiten B im Bereich von 70 bis 120 µm, können jedoch mit Abstrichen an der Temperaturhomogenität innerhalb aufzuheizenden Gebiet HG oder mit Abstrichen an der maximal erreichbaren Temperatur im Zentrum des aufzuheizenden Gebiets wesentlich größer oder auch geringfügig kleiner gewählt werden. Eine Erhöhung der maximal erreichbaren Temperatur innerhalb des aufzuheizenden Gebiets erhält man durch eine Verringerung der Breite B sowie durch eine Erhöhung der Stromtragfähigkeit oder eine Weiterverbesserung der Spannungsfestigkeit, die das Anlegen einer höheren Heizleistung an die als Heizwiderstand fungierende dotierte Zone DZ ermöglicht. Auch die maximale Tiefe des aufzuheizenden Gebiets, also mithin die Tiefe des Gebiets mit gewünschter hoher Temperaturhomogenität, kann ebenfalls erhöht werden, wenn gleichzeitig die lateralen Dimensionen des aufzuheizenden Gebiets verringert werden, wenn also ein höherer Abstand zur diffundierten Zone eingestellt wird. Dadurch wird ein entsprechend steilerer Verlauf der Isothermen (siehe Temperaturverteilung in Figur 6A) erzielt.

Mit der Regelschaltung lässt sich die mittlere Temperatur des aufzuheizenden Gebiets einstellen und kontrollieren.

Prinzipiell lässt sich der Bauelementkörper mit Heizstruktur und den im aufzuheizenden Gebiet angeordneten funktionellen Bauelementstrukturen auch mit anderen Halbleitermaterialien realisieren, in denen mit einer Dotierung der Leitfähigkeitstyp verändert werden kann.

### Bezugszeichenliste

- HLK: Halbleiterkörper (HLK)
- HG: aufzuheizendes Gebiet
- DZ: ringformig geschlossene diffundierte Zone
- KO: elektrischen Kontakte für DZ
- WDZ: ringförmige Wanne für DZ
- ZW: zentrale Wanne für HG
- WR: Wannenring
- SRI: innerer Substratring
- SRA: äußerer Substratring
- IS: Isolierschicht

## Patentansprüche

1. Halbleiterkörper mit integrierter Heizstruktur,
- wobei der Halbleiterkörper (HLK) eine Grunddotierung von einem ersten Leitfähigkeitstyp aufweist,
- mit einer zentralen Wanne (ZW), die mit einem Dotierstoff vom entgegengesetzten zweiten Leitfähigkeitstyp dotiert ist,
- mit einem geschlossenen dotierten Wannenring (WR), der im Randbereich der zentralen Wanne angeordnet ist, mit einem Wannenkontakt versehen ist und mit einem Dotierstoff vom zweiten Leitfähigkeitstyp höher dotiert ist als die zentrale Wanne,
- mit einem aufzuheizenden Gebiet (HG), das in einem oberen Schichtbereich des Halbleiterkörpers innerhalb des Wannenrings angeordnet ist,
- mit funktionellen Bauelementstrukturen, die im oder auf dem aufzuheizenden Gebiet angeordnet sind und beim bestimmungsgemäßen Betrieb eine über der Raumtemperatur liegende Betriebstemperatur erfordern,
- mit einer diffundierten Zone (DZ), die das aufzuheizende Gebiet ringförmig mit runder, elliptischer oder ovaler Ausformung oder den Kanten eines Rechtecks folgend im Abstand umschließt und mit einem Dotierstoff vom zweiten Leitfähigkeitstyp hoch dotiert ist und die als Widerstandsheizelement vorgesehen ist, welches ein schnelles Aufheizen im Bereich der Heizstruktur ermöglicht,
- mit zwei elektrischen Kontakten (KO) an der diffundierten Zone, die einander im Ring diametral gegenüberliegen oder an den Mitten zweier gegenüberliegender Rechteckseiten angeordnet sind,
- wobei zwischen diffundierter Zone und zentraler Wanne ein innerer Substratring (SRI) vorgesehen ist, welcher eine gegenüber der Grunddotierung des Halbleiterkörpers erhöhte Dotierung vom ersten Leitfähigkeitstyp aufweist und mit einem Substratkontakt verbunden ist, und außerhalb der diffundierten Zone im Abstand dazu ein äußerer Substratring (SRA) mit einer gegenüber der Grunddotierung erhöhten Dotierung vom ersten Leitfähigkeitstyp vorgesehen und mit einem Substratkontakt verbunden ist, wobei der äußere Substratring (SRA) die diffundierte Zone (DZ) ringförmig umschlieβt, und
- mit Mitteln zum Regeln der Temperatur im aufzuheizenden Gebiet, die eine Regelschleife und einen Temperatursensor umfassen.

2. Halbleiterkörper nach Anspruch 1, bei dem die diffundierte Zone (DZ) eine nur schwach mit einem Dotierstoff vom zweiten Leitfähigkeitstyp dotierte ringförmige Wanne und ein konzentrisch darin angeordnetes hoch dotiertes ringförmiges Zentrum umfasst.

3. Halbleiterkörper nach Anspruch 1 oder 2, bei dem die diffundierte Zone (DZ) in eine niedriger dotierte Wanne eingebettet ist, die den RESURF Effekt ausnutzt, um den lateralen Oberflächenabbruch zu vermeiden.

4. Halbleiterkörper nach einem der Ansprüche 1 bis 3, bei dem
im aufzuheizenden Gebiet (HG) als funktionelle Bauelementstruktur ein Mikroreaktor für mikrobiologische oder chemische Reaktionen realisiert ist.

5. Verfahren zum Betrieb eines Halbleiterkörpers nach einem der Ansprüche 1 bis 4, bei dem
an die zwei elektrischen Kontakte (KO) an der diffundierten Zone (DZ) eine elektrische Spannung zur Erzeugung eines Heizstromes angelegt wird und
an die zentrale Wanne (ZW) über den Wannenring (WR) sowie an den inneren Substratring (SRI) und an den äußeren Substratring (SRA) jeweils ein elektrisches Potential angelegt wird.

## Claims

1. A semiconductor body comprising an integrated heating structure,
- the semiconductor body (HLK) comprising a basic doping of a first conductivity type,
- comprising a central well (ZW) doped with a dopant of an opposite, second conductivity type,
- comprising a closed doped well ring (WR) which is arranged in the peripheral area of the central well, provided with a well contact and doped with a dopant of the second conductivity type at a higher level than the central well,
- comprising an area (HG) to be heated and arranged in an upper layer region of the semiconductor body within the well ring,
- comprising functional device structures which are arranged in or on the area to be heated and, for the intended operation, require an operating temperature which is above room temperature,
- comprising a diffused zone (DZ) which encloses the area to be heated with a distance with a round, elliptic or oval form or so as to follow the edges of a rectangle and is highly doped with a dopant of the second conductivity type and provided as a resistance heating element allowing a quick heat-up process in the region of the heating structure,
- comprising two electrical contacts (KO) on the diffused zone, which are arranged in the ring so as to be diametrically opposite each other or are arranged in the middle of two opposite sides of the rectangle,
- an inner substrate ring (SRI) being provided between the diffused zone and the central well, which inner substrate ring has a doping of the first conductivity type which is elevated with respect to the basic doping of the semiconductor body and is connected to a substrate contact, and an outer substrate ring (SRA) being provided outside the diffused zone so as to be spaced from it, which outer substrate ring has a doping of the first conductivity type which is elevated with respect to the basic doping and is connected to a substrate contact, the outer substrate ring (SRA) enclosing the diffused zone (DZ) in the form of a ring, and
- comprising means intended for regulating the temperature in the area to be heated and comprising a control loop and a temperature sensor.

2. The semiconductor body according to claim 1, in which the diffused zone (DZ) comprises a ring-shaped well which is only weakly doped with a dopant of the second conductivity type and comprises a highly doped ring-shaped center concentrically arranged therein.

3. The semiconductor body according to claim 1 or 2, in which the diffused zone (DZ) is embedded in a well which has a lower doping level and uses the RESURF effect in order to avoid the lateral surface break-off.

4. The semiconductor body according to any of the claims 1 to 3, in which
a micro reactor for microbiological or chemical reactions is realized as the functional device structure in the area (HG) to be heated.

5. A method of operating a semiconductor body according to any of the claims 1 to 4, in which
an electrical voltage is applied to the two electrical contacts (KO) on the diffused zone (DZ), for generating a heating current and
an electrical potential is applied to the central well (ZW) via the well ring (WR) as well as to the inner substrate ring (SRI) and the outer substrate ring (SRA).

## Revendications

1. Corps semi-conducteur à structure chauffante intégrée,
- le corps semi-conducteur (HLK) présentant un dopage de base d'un premier type de conductibilité,
- comportant une cuvette centrale (ZW) qui est dopée par un dopant du deuxième type de conductibilité opposé,
- comportant un anneau de cuvette fermé dopé (WR) qui est disposé dans la zone du bord de la cuvette centrale, qui est pourvu d'un contact de cuvette et qui est dopé par un dopant du deuxième type de conductibilité de manière plus élevée que la cuvette centrale,
- comportant une région à réchauffer (HG) qui est disposée dans une zone de couche supérieure du corps semi-conducteur à l'intérieur de l'anneau de cuvette,
- comportant des structures de composants fonctionelles qui sont disposées dans ou sur la région à réchauffer et qui nécessitent, en fonctionnement conforme à la destination prévue, une température de fonctionnement supérieure à la température ambiante,
- comportant une zone diffusée (DZ) qui entoure à distance et de manière annulaire la région à réchauffer par une formation ronde, elliptique ou ovale ou en suivant les côtés d'un rectangle, qui est hautement dopée par un dopant du deuxième type de conductibilité et qui est prévue comme élément chauffant par résistance, lequel permet un réchauffement rapide dans la zone de la structure chauffante,
- comportant au niveau de la zone diffusée deux contacts électriques (KO) qui sont diamétralement opposés l'un à l'autre dans l'anneau ou qui sont disposés aux milieux de deux côtés opposés d'un rectangle,
- un anneau de substrat intérieur (SRI) étant prévu entre la zone diffusée et la cuvette centrale, présentant un dopage du premier type de conductibilité supérieur au dopage de base du corps semi-conducteur et étant relié à un contact de substrat, et un anneau de substrat extérieur (SRA) étant prévu à l'extérieur de la zone diffusée à distance de celle-ci, présentant un dopage du premier type de conductibilité supérieur au dopage de base et étant relié à un contact de substrat, l'anneau de substrat extérieur (SRA) entourant la zone diffusée (DZ) de manière annulaire, et
- comportant dans la région à réchauffer des moyens de régulation de la température qui comprennent une boucle de régulation et un capteur de température.

2. Corps semi-conducteur selon la revendication 1, où la zone diffusée (DZ) comporte une cuvette de forme annulaire qui n'est que faiblement dopée par un dopant du deuxième type de conductibilité et un centre de forme annulaire hautement dopé qui s'y trouve disposé concentriquement.

3. Corps semi-conducteur selon la revendication 1 ou 2, où la zone diffusée (DZ) est logée dans une cuvette moins dopée qui exploite l'effet RESURF pour éviter l'interruption latérale de surface.

4. Corps semi-conducteur selon l'une des revendications 1 à 3, où
un microréacteur pour réactions microbiologiques ou chimiques est réalisé comme structure de composants fonctionelle dans la région à réchauffer (HG).

5. Procéder de fonctionnement d'un corps semi-conducteur selon l'une des revendications 1 à 4, où
une tension électrique est appliquée aux deux contacts électriques (KO) au niveau de la zone diffusée (DZ) pour générer un courant chauffant et un potentiel électrique est appliqué respectivement à la cuvette centrale (ZW) via l'anneau de cuvette (WR) ainsi qu'à l'anneau de substrat intérieur (SRI) et à l'anneau de substrat extérieur (SRA).
